# EUROPÄISCHE PATENTANMELDUNG

(11) **EP 0 541 916 A1**
(43) Veröffentlichungstag der Anmeldung: **19.05.1993**
(21) Anmeldenummer: 92114502.5
(22) Anmeldetag: 26.08.1992
(51) Int. Cl.: H01L 21/316, H01L 21/314, C23C 16/40, C23C 16/32, C23C 16/50

(54) **Verfahren zur Oberflächenpassivierung von Sensoren**

(30) Priorität: 11.11.1991 DE 4136987
(71) Anmelder: LEYBOLD AKTIENGESELLSCHAFT, D-63450 Hanau (DE)
(72) Erfinder: Gegenwart, Rainer, Dr., W-6074 Rödermark (DE); Ritter, Jochen, W-6312 Lauchbach 1 (DE); Stoll, Helmut, W-6231 Sulzbach (DE); Weimer, Norbert, W-6330 Wetzlar (DE); Wurczinger, Hans-Dieter, W-6368 Bad Vilbel (DE)

(57) **Zusammenfassung**

Beschrieben wird ein Verfahren zur elektrischen und mechanischen Oberflächenpassivierung von Sensoren, z.B. Halbleitersensoren, unter Verwendung einer Vakuumanlage, mit einem Rezipienten mit Anschlüssen für Gas-Ein- und Gas-Auslaßleitungen, einer Anode und einer Kathode, über der eine Substrathaltevorrichtung angebracht ist, zur Durchführung einer Beschichtung des Sensors mit einer Materialsschicht nach dem CVD-Verfahren mit einer plasmaunterstützten Schichtdeposition sowie mit Meß- und Regeleinrichtungen für die den Sputterprozeß bestimmenden Prozeßparameter, wie Gasfluß, Druck und die in das Plasma eingekoppelte elektrische Leistung.

Die Erfindung zeichnet sich dadurch aus, daß in einem ersten Verfahrensschritt ein Füllgases in den Rezipienten eingeleitet wird und die Elektroden mit einer Hochfrequenz zur Entzündung eines Plasmas innerhalb des Rezipienten beaufschlagt werden. Anschließend wird die Sensoroberfläche durch Absputtern von Verunreinigungen aus der Sensoroberfläche mittels auf die Sensoroberfläche treffender Plasmapartikel gereinigt. In einem weiteren Schritt wird ein Silizium enthaltendes Monomer und ein Zusatzgas in den Rezipienten unter kontinuierlicher Drosselung der Zugabe des Füllgases und Aufrechternaltung des Plasmas eingeleitet, wobei die elektronischen Kenndaten der in das Plasma eingekoppelten elektrischen Leistung erfasst werden. Schließlich führt dies zur Abscheidung einer aus dem Silizium enthaltenden Monomers und Zusatzgas entstehenden Verbindung auf der Sensoroberfläche.

## Beschreibung

Die Erfindung bezieht sich auf ein Verfahren zur elektrischen und mechanischen Oberflächenpassivierung von Sensoren, z.B. Halbleitersensoren, unter Verwendung einer Vakuumanlage, mit einem Rezipienten mit Anschlüssen für Gas-Ein- und Gas-Auslaßleitungen, einer Anode und einer Kathode, über der eine Substrathaltevorrichtung angebracht ist, zur Durchführung einer Beschichtung des Sensors mit einer Materialschicht nach dem CVD-Verfahren mit einer plasmaunterstützten Schichtdeposition sowie mit Meß- und Regeleinrichtungen für die den Sputterprozeß bestimmenden Prozeßparameter, wie Gasfluß, Druck und die in das Plasma eingekoppelte elektrische Leistung.

Zur Herstellung von elektronischen Bauelementen, wie z.B. Sensoren, insbesondere Halbleitersensoren, Mikrochipbausteinen und weiteren hochintegrierten Bauelementen, um nur einige zu nennen, ist es erforderlich, das Innere der jeweiligen Bausteinkörper sowohl vor äußeren Einflüssen als auch internen Spannungskurzschlüssen zu schützen. Gerade der zumeist filligrane Aufbau mikromechanischer Halbleitersensoren, wie zum Beispiel bei Drucksensoren, bedingt für das Aufbringen von Leitbahnen auf den Sensorflächen elektrisch isolierende Zwischenschichten, die einen elektrischen Kurzschluß zum Sensorgrundsubstrat verhindern sollen. Ebenso ist es bei Meßbausteinen, die einer chemisch aggressiven Atmosphäre ausgesetzt werden, erforderlich einen Schutzüberzug über den Baustein vorzusehen, damit die Haltbarkeit und Resistenz gegenüber der chemisch aggressiven Umgebung erhöht wird.

Zum Aufbringen derartiger Schutz- bzw. Isolationsschichten auf die entsprechenden Grundsubstrate werden bislang klassische Beschichtungsverfahren wie z.B. das thermische Verdampfen oder das Aufsputtern bestimmter Substanzen verwendet. Nachteilhaft sind zum einen hohe Betriebstemperaturen, was z.B. das Beschichten von temperaturempfindlichen Grundsubstraten unmöglich macht, sowie eine nur beschränkt vornehmbare Beeinflussung der Schichtparameter, wie z.B. Härte, Dichte, elektrische Eigenschaft, Brechungsindex und Zusammensetzung der Schicht.

Zur preisgünstigen Herstellung von Beschichtungen derartiger Substrate in großen Stückzahlen ist zudem eine einfache Prozeßführung mit stabil zu haltenden Pozeßbedingungen während der gesamten Betriebszeit erforderlich.

Der Erfindung liegt die Aufgabe zugrunde, ein Verfahren zur elektrischen und mechanischen Oberflächenpassivierung von Sensoren, z.B. Halbleitersensoren, unter Verwendung einer Vakuumanlage derart anzugeben, so daß die mit dem erfindungsgemäßen Verfahren herstellbaren Schichten in einer einfachen Prozeßführung mit hoher Stabilität und Reproduzierbarkeit sowie mit hohen Abscheiderraten in großindustriellem Maßstab produziert werden können. Darüberhinaus sollen die Schichten über eine steuerbar hohe Dichte, geringe Oberflächenrauhigkeit sowie über hohe Haftfestigkeiten und hohe Korrosionsbeständigkeiten verfügen. Ferner sollen die an dem Beschichtungsprozeß beteiligten Verbrauchsmaterialien preisgünstig sein und umweltverträgliche Eigenschaften besitzen.

Eine erfindungsgemäße Lösung dieser Aufgabe ist im Anspruch 1 angegeben. Weiterbildungen der Erfindung sind Gegenstand der Unteransprüche.

Erfindungsgemäß wird ein Verfahren zur elektrischen und mechanischen Oberflächenpassivierung von Sensoren, z.B. Halbleitersensoren, unter Verwendung einer Vakuumanlage, mit einem Rezipienten mit Anschlüssen für Gas-Ein- und Gas-Auslaßleitungen, einer Anode und einer Kathode, über der eine Substrathaltevorrichtung angebracht ist, zur Durchführung einer Beschichtung des Sensors mit einer Materialschicht nach dem CVD-Verfahren mit einer plasmaunterstützten Schichtdeposition sowie mit Meß- und Regeleinrichtungen für die den Sputterprozeß bestimmenden Prozeßparameter, wie Gasfluß, Druck und die in das Plasma eingekoppelte elektrische Leistung, derart angegeben, so daß in einem ersten Verfahrensschritt ein Füllgas in den Rezipienten eingeleitet wird und die Elektroden mit einer Hochfrequenz beaufschlagt werden, um im Rezipienten ein Plasma zu entzünden. Ein zweiter Verfahrensschritt sieht die Reinigung der Sensoroberfläche durch Absputtern von Verunreinigungen aus der Sensoroberfläche mittels auf die Sensoroberfläche auftreffender Plasmapartikel vor. In einem dritten Verfahrensschritt wird ein Silizium enthaltendes Monomer und ein Zusatzgas in den Rezipienten unter kontinuierlicher Drosselung der Zugabe des Füllgases eingeleitet, wobei das Plasma aufrechterhalten bleibt. Zur Kontrolle der in das Beschichtungsverfahren eingekoppelten elektrischen Leistung werden hierzu alle notwendigen elektronischen Kenndaten gemessen. Als Folge der elektrischen und thermischen Verhältnisse auf der Substratoberfläche scheidet sich eine aus dem Silizium enthaltenden Monomer und dem Zusatzgas entstehende Verbindung auf ihr ab.

Das an sich bekannte CVD-Verfahren (Chemical Vapour Deposition), das in der erfindungsgemäßen Anwendung im wesentlichen einer plasmaaktivierten Gasphasenabscheidung entspricht, besitzt gegenüber den übrigen Schichtabscheideprozessen den Vorteil, vollkommen isotrope Abscheidungen auf strukturierten oder gewölbten Substratoberflächen zu gewährleisten. Zudem ermöglichen Verfahrenstemperaturen von unterhalb 150 °C die Beschichtung von z.B. Kunststoffen oder empfindlichen elektronischen Bauteilen, die einer hohen thermischen Belastung nicht Stand halten können.

Das Aufbringen von hochisolierenden Schichten auf metallischen Unterlagen auf die weitere Schichten leitfähig oder isolierend oder in Kombination aufgebracht werden, ist für eine spätere Verarbeitung zu einem Sensor, z.B. Drucksensor bzw. Dehnungsmeßstreifen unabdingbare Voraussetzung. Hierbei kommt es hauptsächlich darauf an, daß die zum Teil hauchdünnen Membranen, die u.a. mit den Mitteln der Mikromechanik hergestellt werden können, nur in begrenzten Bereichen mechanisch, thermisch und chemisch durch den Beschichtungsvorgang beanspruchbar sind. Es gilt daher bei der Beschichtung ein Verfahren zu wählen, das besonders "behutsam" die Aufbringung derartig hochisolierender Schichten vornimmt. Gleichzeitig werden jedoch hohe Anforderungen an die Isolationsschichten gestellt. Hierbei wird besonderer Wert auf die hohe Schichtdichte, Durchschlagsfestigkeit, geringe Oberflächenrauhigkeit, hohe Haftfestigkeit und Korrosionsbeständigkeit gelegt.

Das erfindungsgemäße Verfahren, wie es im Anspruch 1 dargestellt wird, sieht zum einen, einen die Substratoberfläche, auf die die abzuscheidenden Isolationsschicht aufgebracht werden soll, reinigenden Sputterprozeß vor, der aus der Substratoberfläche alle auf ihr abgeschiedenen Verunreinigungen, z.B. Oberflächenfeuchtigkeit, entfernt. Hierbei handelt es sich im wesentlichen um Argon-Ionen, die auf die Substratoberfläche auftreffen und aufgrund von Ionisation sich aus dem in das Rezipientengehäuse geleiteten Füllgas Argon bilden. Das zu beschichtende Substrat ist dabei in unmittelbarer Nähe zur Kathodenfläche angeordnet, die sich gegenüber dem Rezipientengehäuse, das der auf Masse liegenden Anode entspricht, auf negativen Potential befindet. Das elektrische Potential des Substrats ist dabei nicht näher festgelegt, sodaß es auch als "floatend" angesehen werden kann. Zwischen Kathode und Anode herrscht eine Hochfrequenz mit etwa 13,56 MHz.

Das vorwiegend aus Argon-Ionen bestehende Plasma, das sich zwischen den Elektroden ausbildet, wird in einem nächsten Verfahrensschritt mit Silizium enthaltende Monomere und einem Zusatzgas, z.B. Sauerstoff oder Stickstoff, versetzt. Das Plasma wird dabei stets unter ständiger Kontrolle der in das Plasma eingekoppelten elektrischen Leistung aufrecht erhalten.

Die auf das Substrat abzuscheidenden Materialien werden somit gasförmig in das Rezipientengehäuse eingelassen, in einer Hochfrequenzentladung dissoziiert und auf dem Substrat abgeschieden. Durch die genannten Zusatzgase können sie dann zu Oxiden oder Nitriden reagieren.

Durch die Wahl der Beschichtungsparameter Gasdruck im Innern des Rezipienten sowie Gaszusammensetzung, die durch den Gasfluß regelbar ist, als auch die in das Plasma eingekoppelte Leistung, ist eine beliebige Variation der Schichteneigenschaften möglich.
Als besonders vorteilhaft haben sich Silizium-Monomerverbindungen erwiesen, die in Verbindung mit dem Zusatzgas zu SiO₂-, SiC-, SiₓO_{y}-C-Schichten führen. So eignen sich als Monomerverbindungen bevorzugt Tetraethoxysilane (TEOS), Hexamethyldisilizane (HMDS), Tetramethyldisilane (TMS) sowie einfache Silane.

Mit diesem Verfahren ist es ertsmals gelungen auf mechanisch und thermisch hochsensiblen Substraten hochisolierende Schichten haftfest aufzubringen, die trotz der erschwerten Verfahrensbedingungen zu mechanisch und chemisch widerstandsfähigen Schichten, auch im Sinne von Schutzschichten, führen. So sind neben den genannten Anwendungen auch an Schutzschichten für die Optik, Oberflächenhärtung von Kunststoffen, dielektrische Schichten für die Mikroelektronik sowie Anwendungen aus dem Bereich der integrierten Optik zu denken.

## Patentansprüche

1. Verfahren zur elektrischen und mechanischen Oberflächenpassivierung von Sensoren, z.B. Halbleitersensoren, unter Verwendung einer Vakuumanlage,
mit einem Rezipienten mit Anschlüssen für Gas-Ein- und Gas-Auslaßleitungen,
einer Anode und einer Kathode, über der eine Substrathaltevorrichtung angebracht ist,
zur Durchführung einer Beschichtung des Sensors mit einer Materialsschicht nach dem CVD-Verfahren mit einer plasmaunterstützten Schichtdeposition sowie
mit Meß- und Regeleinrichtungen für die den Sputterprozeß bestimmenden Prozeßparameter, wie Gasfluß, Druck und die in das Plasma eingekoppelte elektrische Leistung, gekennzeichnet durch die Kombination folgender Verfahrensschritte:
- Einleitung eines Füllgases in den Rezipienten und Beaufschlagung der Elektroden mit einer Hochfrequenz zur Entzündung eines Plasmas innerhalb des Rezipienten,
- Reinigung der Sensoroberfläche durch Absputtern von Verunreinigungen aus der Sensoroberfläche mittels auf die Sensoroberfläche treffender Plasmapartikel,
- Einleitung eines Silizium enthaltenden Monomers und eines Zusatzgases in den Rezipienten unter kontinuierlicher Drosselung der Zugabe des Füllgases und Aufrechterhaltung des Plasmas,
- Messung der elektronischen Kenndaten der in das Plasma eingekoppelten elektrischen Leistung.
- Abscheidung einer aus dem Silizium enthaltenden Monomers und Zusatzgas entstehenden Verbindung auf die Sensoroberfläche.

2. Verfahren nach Anspruch 1,
dadurch **gekennzeichnet**, daß die Materialschicht elektrisch hochisolierend ist.

3. Verfahren nach Anspruch 1 oder 2,
dadurch **gekennzeichnet**, daß die Materialschicht chemisch inert gegen Säuren, Laugen und aggressive Gase ist.

4. Verfahren nach Anspruch 1 bis 3,
dadurch **gekennzeichnet**, daß das Zusatzgas molekularer Sauerstoff oder Stickstoff, bzw. Sauerstoff oder Stickstoffverbindungen ist.

5. Verfahren nach einem der Ansprüche 1 bis 4,
dadurch **gekennzeichnet**, daß die Isolationsschicht aus SiO₂ besteht.

6. Verfahren nach einem der Ansprüche 1 bis 5,
dadurch **gekennzeichnet**, daß die Isolationsschicht aus SiC besteht.

7. Verfahren nach einem der Ansprüche 1 bis 6,
dadurch**gekennzeichnet,** daß die Isolationsschicht aus dem Verbindungstyp SiₓO_{y}-C besteht.

8. Verfahren nach einem der Ansprüche 1 bis 7,
dadurch **gekennzeichnet**, daß die maximale Verfahrenstemperatur 150 °C beträgt.

9. Verfahren nach einem der Ansprüche 1 bis 8,
dadurch **gekennzeichnet**, daß die zu beschichtende Sensoroberfläche metallisch und leitfähig ist.

10. Verfahren nach einem der Ansprüche. 1 bis 9,
dadurch **gekennzeichnet**, daß die zu beschichtende Sensoroberfläche aus Kunststoff ist.

11. Verfahren nach einem der Ansprüche 1 bis 10,
dadurch **gekennzeichnet**, daß das Siliziummonomer aus Tetraethoxysilan (TEOS) besteht.

12. Verfahren nach einem der Ansprüche 1 bis 11,
dadurch **gekennzeichnet**, daß das Siliziummonomer Hexamethyldisilazan (HMDS) ist.

13. Verfahren nach einem der Ansprüche 1 bis 12,
dadurch **gekennzeichnet**, daß das Siliziummonomer Tetramethyldisilan (TMS) ist.

14. Verfahren nach einem der Ansprüche 1 bis 13,
dadurch **gekennzeichnet**, daß das Siliziummonomer Silan ist.

15. Verfahren nach einem der Ansprüche 1 bis 14,
dadurch **gekennzeichnet**, daß während des Gaswechsels beim Übergang von reiner Füllgasatmosphäre im Rezipienten zum Siliziummonomer-Zusatzgas Gemisch die elektrische Rückwärtsleistung mittels eines automatischen Regelkreises minimierbar ist.

16. Verfahren nach einem der Ansprüche 1 bis 15,
dadurch **gekennzeichnet**, daß der Halbleitersensor ein Drucksensor ist.

17. Verfahren nach einem der Ansprüche 1 bis 16,
dadurch **gekennzeichent**, daß der Halbleitersensor ein Dehnungsmeßstreifen ist.

18. Verfahren nach einem der Ansprüche 1 bis 17,
dadurch **gekennzeichnet**, daß die an den Elektroden anliegende Hochfrequenz etwa 13,56 MHz beträgt.

19. Verfahren nach einem der Ansprüche 1 bis 18,
dadurch **gekennzeichnet**, daß die auf die Sensoroberfläche auftreffende Plasmapartikel Ar⁺-Ionen sind.

20. Verfahren nach einem der Ansprüche 1 bis 19,
dadurch **gekennzeichnet**, daß die zu bedampfenden Substrate mechanisch hochsensible Sensorbauelemente sind.
